(19) Europäisches Patentamt
European Patent Office
Office européen des brevets

(11) **EP 3 557 743 A1**

(12) **DEMANDE DE BREVET EUROPEEN**

(43) Date de publication:
**23.10.2019 Bulletin 2019/43**

(51) Int Cl.:
*H02M 3/156* (2006.01)     *H02M 3/158* (2006.01)
*H02M 1/00* (2006.01)     *G11C 5/14* (2006.01)

(21) Numéro de dépôt: **19167173.4**

(22) Date de dépôt: **03.04.2019**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **17.04.2018 FR 1853366**

(71) Demandeur: **STMicroelectronics (ALPS) SAS
38000 Grenoble (FR)**

(72) Inventeur: **ARNO, Patrik
38360 SASSENAGE (FR)**

(74) Mandataire: **Cabinet Beaumont
4, Place Robert Schuman
B.P. 1529
38025 Grenoble Cedex 1 (FR)**

(54) **ALIMENTATION À DÉCOUPAGE**

(57) L'invention concerne une alimentation à découpage dans laquelle la tension de référence (VREF) de la boucle de rétroaction a une valeur réglable.

Fig 4

# Description

Domaine

La présente demande concerne les alimentations à découpage et leurs modes de fonctionnement.

Exposé de l'art antérieur

Les alimentations à découpage sont des convertisseurs DC/DC qui incorporent un ou plusieurs éléments de commutation. Comme les autres types d'alimentations, les alimentations à découpage transfèrent une puissance fournie par une source DC à une charge, en modifiant une des caractéristiques de courant ou de tension.

Résumé

Un mode de réalisation prévoit une alimentation à découpage comprenant des premier et deuxième transistors connectés en série, entre la masse et un noeud d'application de la tension d'alimentation, le premier transistor étant apte à être commandé par le signal de sortie d'une porte logique ET connectée en entrée à un circuit de génération de signaux de commande des premier et deuxième transistors et à un noeud d'application d'une tension apte à maintenir le premier transistor fermé quelle que soit la valeur des signaux de commande générés par le circuit de génération, dans laquelle la tension de référence de la boucle de rétroaction a une valeur réglable.

Selon un mode de réalisation, l'alimentation est un convertisseur abaisseur, la tension de référence étant adaptée à prendre une valeur supérieure ou égale à la valeur de la tension d'alimentation divisée par le gain en boucle fermée du système.

Selon un mode de réalisation, l'alimentation est un convertisseur élévateur, la tension de référence étant adaptée à prendre une valeur inférieure ou égale à la valeur de la tension d'alimentation divisée par le gain en boucle fermée du système.

Selon un mode de réalisation, l'alimentation comprend des premier et deuxième transistors connectés en série, le premier transistor étant connecté entre la masse et un premier noeud et le deuxième transistor étant connecté entre le premier noeud et un noeud d'application de la tension d'alimentation, les premier et deuxième transistors étant aptes à être commandés par un circuit de génération des signaux de commande des premier et deuxième transistors.

Selon un mode de réalisation, l'alimentation comprend un premier circuit apte à détecter si le rapport cyclique d'un signal d'entrée du circuit de génération est sensiblement égal à 100 %.

Selon un mode de réalisation, l'alimentation comprend un deuxième circuit apte à maintenir le deuxième transistor passant si le rapport cyclique du signal d'entrée du circuit de génération est sensiblement égal à 100 %.

Selon un mode de réalisation, le deuxième circuit comprend une porte ET.

Selon un mode de réalisation, le premier circuit comprend un compteur dont l'entrée de mise à zéro est connectée au signal d'entrée du circuit de génération.

Selon un mode de réalisation, la boucle de rétroaction est située entre le noeud de sortie de l'alimentation et un deuxième noeud.

Selon un mode de réalisation, le deuxième noeud est couplé à la masse par une première résistance, le deuxième noeud étant couplé au noeud de sortie par une deuxième résistance.

Selon un mode de réalisation, la tension de référence est fournie par un troisième circuit comprenant une boucle de rétroaction résistive de résistance réglable.

Selon un mode de réalisation, la tension de référence est fournie par un troisième circuit comprenant une boucle de rétroaction résistive dont la sortie est couplée à la sortie du circuit par un bloc résistif de résistance réglable.

Un autre mode de réalisation prévoit un procédé d'utilisation d'une alimentation comprenant des premier et deuxième transistors connectés en série, entre la masse et un noeud d'application de la tension d'alimentation, le premier transistor étant apte à être commandé par le signal de sortie d'une porte logique ET connectée en entrée à un circuit de génération de signaux de commande des premier et deuxième transistors et à un noeud d'application d'une première tension, le procédé comprenant le passage d'un premier état de la tension de référence de la boucle de rétroaction à un deuxième état et comprenant un mode de fonctionnement dans lequel la première tension maintient le premier transistor fermé quelle que soit la valeur des signaux de commande générés par le circuit de génération.

Selon un mode de réalisation, l'alimentation est un convertisseur abaisseur, et la tension de référence dans le deuxième état est supérieure ou égale à la tension d'alimentation divisée par le gain en boucle fermée du système.

Selon un mode de réalisation, l'alimentation est un convertisseur élévateur, et la tension de référence dans le deuxième état est inférieure ou égale à une tension d'alimentation divisée par le gain en boucle fermée du système.

Selon un mode de réalisation, le procédé comprend :

déterminer, par un premier circuit, si le rapport cyclique d'un signal d'entrée du circuit de génération des signaux de commande de deux transistors est sensiblement égal à 100 % ; et
éteindre les composants de l'alimentation autres qu'un deuxième circuit assurant la connexion entre la sortie de l'alimentation et un noeud d'application de la tension d'alimentation.

## Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une représentation schématique d'un exemple d'alimentation à découpage ;
la figure 2 est une représentation schématique d'un mode de réalisation d'une alimentation à découpage ;
la figure 3 illustre un mode de fonctionnement de l'alimentation à découpage de la figure 2 ;
la figure 4 est une représentation schématique d'un autre mode de réalisation d'une alimentation à découpage ;
les figures 5, 6 et 7 représentent partiellement des variantes du mode de réalisation de la figure 2 ;
les figures 8 et 9 représentent partiellement des variantes du mode de réalisation de la figure 4 ; et
la figure 10 est une représentation schématique d'un autre mode de réalisation d'alimentation à découpage.

## Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des éléments concernés dans les figures. Sauf précision contraire, les expressions "approximativement", "sensiblement", et "de l'ordre de" signifient à 10 % près, de préférence à 5 % près.

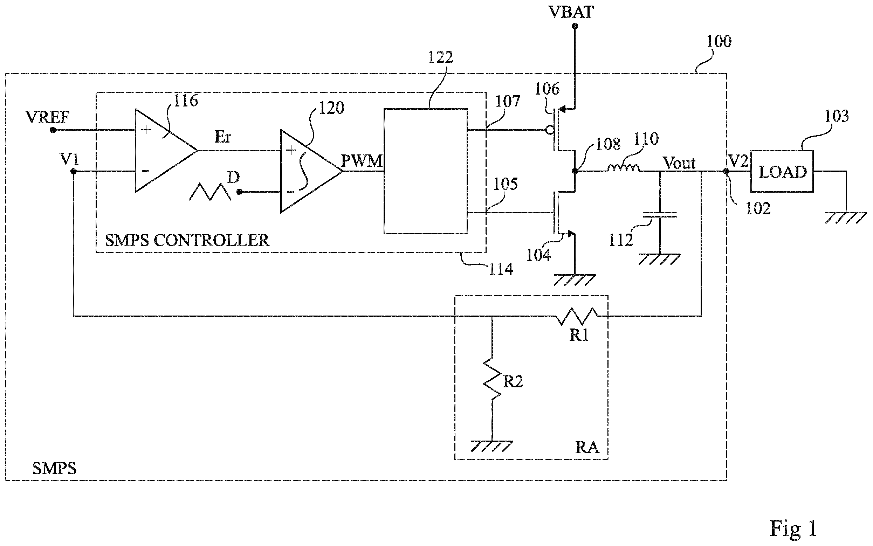

La figure 1 est une représentation schématique d'un exemple d'alimentation à découpage 100 (SMPS) recevant en entrée une tension d'alimentation VBAT et une tension de référence VREF et fournissant une tension Vout à un noeud de sortie 102 (V2). L'alimentation de la figure 1 est un convertisseur abaisseur (buck), c'est-à-dire que la tension Vout est inférieure à la tension d'alimentation VBAT.

Le noeud de sortie 102 est couplé à la masse par une charge 103 (LOAD). La charge 103 est donc alimentée par le convertisseur 100.

Le convertisseur 100 comprend deux interrupteurs 104 et 106 connectés en série entre le noeud d'application de la tension d'alimentation VBAT et la masse. Dans l'exemple de la figure 1, l'interrupteur 104 est un transistor MOS à canal N et l'interrupteur 106 est un transistor MOS à canal P. La source du transistor 106 est connectée à un noeud 108 et son drain est connecté au noeud d'application de la tension VBAT. La source du transistor 104 est connectée à la masse et son drain est connecté au noeud 108. Une inductance 110 est connectée entre les noeuds 108 et 102. Le noeud 102 est, de plus, couplé à la masse par une capacité 112.

Les transistors 104 et 106 sont commandés par un circuit de commande 114 (SMPS CONTROLLER). Plus précisément, le transistor 106 est commandé par une sortie 107 du circuit de commande 114, et le transistor 104 est commandé par une sortie 105 du circuit de commande 114. Le circuit de commande 114 comprend un comparateur 116, par exemple un amplificateur d'erreur. Les entrées du comparateur 116 sont connectées à un noeud d'application de la tension de référence VREF et à un noeud V1. La sortie du comparateur 116 fournit un signal Er, représentatif de la différence de tension entre la tension de référence VREF et la tension du noeud V1.

Le noeud V1 est couplé au noeud de sortie 102 par un bloc résistif RA. L'alimentation 100 comprend donc une boucle de rétroaction résistive entre le noeud de sortie 102 et le noeud V1. On désigne par "tension de rétroaction" la tension du noeud V1, c'est-à-dire la tension d'entrée du circuit de commande dépendant de la tension de sortie Vout.

Le bloc RA comprend par exemple deux résistances, une résistance R1 connectée entre les noeuds 102 et V1 et une résistance R2 connectée entre le noeud V1 et la masse.

Le circuit de commande 114 comprend de plus un comparateur 120 recevant en entrée le signal Er et un signal D périodique en dents de scie. Le comparateur 120 fournit en sortie un signal PWM modulé en largeur d'impulsion (Pulse Width Modulation). Le signal PWM est un signal binaire périodique comprenant un état haut et un état bas. Le rapport cyclique du signal PWM est contrôlé par le signal Er. Ainsi, plus la différence entre la tension de référence VREF et la tension de contre réaction, c'est-à-dire le signal Er, est importante, plus le rapport cyclique du signal PWM est important.

Le circuit de commande 114 comprend de plus un circuit 122 de génération des signaux de commande des transistors 104 et 106. Plus précisément, lorsque le signal PWM est à l'état haut, le circuit 122 ferme l'interrupteur 106 et ouvre l'interrupteur 104 et, lorsque le signal PWM est à l'état bas, le circuit 122 ouvre l'interrupteur 106 et ferme l'interrupteur 104.

Dans certaines conditions, par exemple lorsque la puissance fournie par la source d'alimentation n'est pas suffisamment élevée (est par exemple inférieure à 5 W), l'utilisation d'une alimentation à découpage telle que l'alimentation 100 n'est ni rentable ni efficace.

On peut alors vouloir que le noeud de sortie 102 de l'alimentation à découpage reçoive directement, et de manière continue, la puissance fournie par la source d'alimentation. Il s'agit d'un mode de fonctionnement dit mode Bypass. On pourrait envisager de simplement connecter, par exemple par un interrupteur, la source d'application de la tension VBAT avec le noeud 102. Cependant, la fermeture de cet interrupteur causerait un pic de courant sur le noeud 102. Un tel pic de courant risquerait d'abimer certains éléments de l'alimentation 100, par exemple des interrupteurs faisant la connexion entre deux noeuds ou entre une source d'alimentation et un noeud.

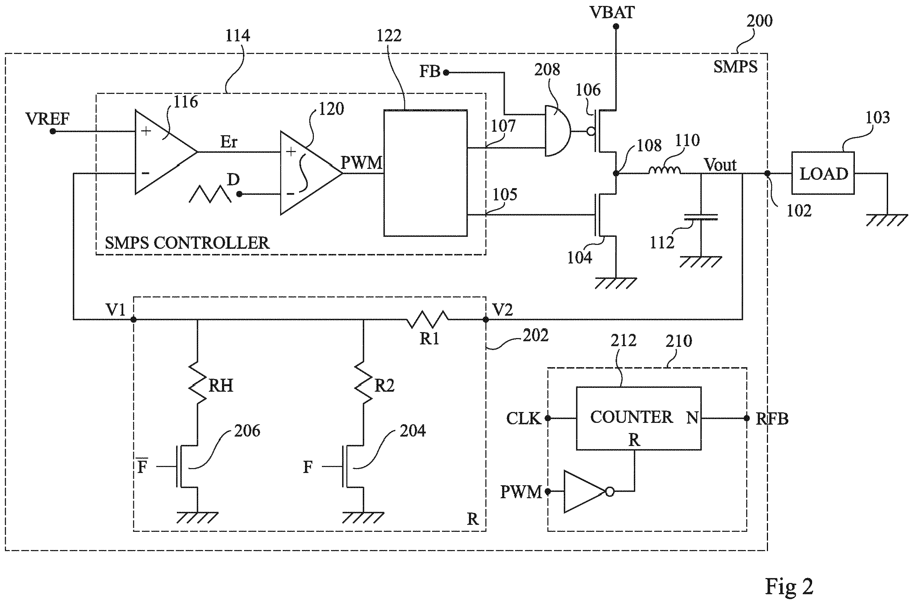

La figure 2 est une représentation schématique d'un mode de réalisation d'une alimentation à découpage 200 alimentant la charge 103 et recevant la tension d'alimentation VBAT. L'alimentation 200 est, comme l'alimentation 100 de la figure 1, un convertisseur abaisseur (buck). L'alimentation 200 comprend les éléments de l'alimentation 100. En particulier, l'alimentation 200 comprend le circuit de commande 114, les interrupteurs 104 et 106, l'inductance 110 et la capacité 112.

La boucle de rétroaction est une boucle de rétroaction résistive de valeur réglable. Plus précisément, la boucle de rétroaction comprend un bloc résistif 202 (R), différent du bloc résistif RA de l'alimentation 100, ayant au moins deux états résistifs. Comme le bloc RA, le bloc R est connecté entre les noeuds V1 et V2 et comprend la résistance R1 connectée entre les noeuds V1 et V2. Le noeud V1 est de plus couplé à la masse par la résistance R2 en série avec un interrupteur 204. L'interrupteur 204 est commandé par un signal binaire F. Le noeud V1 est aussi couplé à la masse par une résistance RH en série avec un autre interrupteur 206. L'interrupteur 206 est commandé par un signal binaire $\overline{F}$ correspondant au signal inverse du signal F. Les interrupteurs 204 et 206 sont par exemple des transistors MOS.

D'autres exemples de blocs résistifs seront décrits par la suite.

L'alimentation 200 comprend, de plus, une porte ET 208, dont les entrées sont connectées à la sortie 107 du circuit de commande 114 et à un noeud d'application d'une tension FB. Le signal de sortie de la porte 208 commande le transistor 106.

La porte ET peut éventuellement être remplacée par un circuit apte à maintenir, sur commande, le transistor 106 fermé.

L'alimentation 200 comprend, de plus, un circuit 210 comprenant un compteur 212 (COUNTER N). Le compteur 212 fournit en sortie un signal RFB et est incrémenté par exemple à chaque front montant d'un signal d'horloge CLK. Le signal d'horloge CLK correspond au signal d'horloge du circuit de commande 114 et, en particulier, le signal d'horloge CLK a la même fréquence que le signal D d'entrée du comparateur 120.

L'entrée R de mise à zéro du compteur 212 est couplée à la sortie du comparateur 120 et reçoit donc le signal PWM ou un signal représentatif du signal PWM. Dans l'exemple de la figure 2, l'entrée R est couplée à la sortie du comparateur 120 par un inverseur. Cependant, cet inverseur peut ne pas être présent. Le compteur est donc remis à zéro à chaque fois que le signal PWM prend la valeur basse.

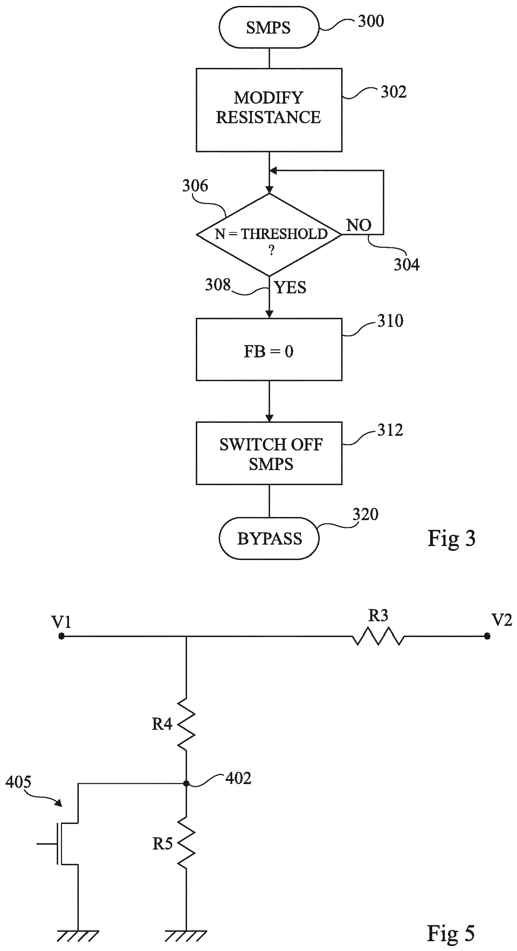

La figure 3 illustre, sous la forme de blocs, un mode de fonctionnement de l'alimentation à découpage 200 de la figure 2.

Le mode de fonctionnement décrit correspond au passage d'un état 300 (SMPS), dans lequel la charge 103 est alimentée par l'alimentation à découpage 200, à un état 320 (BYPASS) en mode Bypass, dans lequel la charge 103 est alimentée directement par la source d'application de tension VBAT, en passant par l'interrupteur 106 du convertisseur.

Le mode de fonctionnement comprend une étape 302 (MODIFY RESISTANCE) au cours de laquelle la résistance du bloc résistif R est modifiée par exemple pour passer d'un premier état à un deuxième état. Les caractéristiques du premier état sont choisies pour que la tension Vout soit inférieure à la tension VBAT et les caractéristiques du deuxième état sont choisies pour que la tension Vout soit égale à la tension VBAT (saturation).

En particulier, dans un premier état du bloc résistif R de l'exemple de la figure 2, le transistor 204 est fermé et le transistor 206 est ouvert. La tension Vout est donc égale à :

$$Vout = VREF * (1 + R1/R2).$$

La tension de référence VREF, ainsi que les résistances R1 et R2, sont choisies pour que la tension Vout soit inférieure à la tension VBAT.

Dans un deuxième état du bloc résistif R de l'exemple de la figure 2, le transistor 204 est ouvert et le transistor 206 est fermé. La tension Vout est donc égale à :

$$Vout = VREF * (1 + R1/RH).$$

Les valeurs de la tension VREF et de la résistance R1 ne changent pas du premier état. La résistance RH est choisie de manière à avoir :

$$VREF * (1 + R1/RH) \geq VBAT.$$

La valeur de la résistance RH est, dans cet exemple, inférieure à la valeur de la résistance R2.

De manière plus générale, la résistance est modifiée de telle manière que le quotient entre la résistance située entre les noeuds V1 et V2 sur la résistance entre le noeud V1 et la masse augmente.

Ce changement d'état du bloc résistif R entraîne une augmentation progressive de la tension V1. La tension V1 augmente alors de manière à être supérieure ou égale à la tension d'alimentation VBAT. Cette augmentation ne comprend pas de pic de courant risquant d'abîmer des composants.

Ce changement d'état du bloc résistif R entraîne une variation du rapport cyclique du signal PWM. Plus précisément, plus la tension V1 augmente, plus le rapport cyclique du signal PWM augmente, jusqu'à atteindre 100 % lorsque la tension Vout devient égale à la tension VBAT.

Tant que le rapport cyclique du signal PWM n'est pas égal à 100 %, le compteur 212 est remis à zéro par le signal PWM une fois par période du signal d'horloge CLK. La valeur N correspondant à la valeur comptée par le compteur 212 ne peut donc atteindre un seuil (THRESHOLD), le seuil ayant été choisi pour être supérieur à 3, par exemple 32. Cela correspond à la branche 304 (NO) de la condition 306 (N = THRESHOLD ?).

Lorsque la valeur de la tension Vout prend une valeur égale à la valeur de la tension VBAT, et que le rapport cyclique du signal PWM devient égal à 100 %, le signal PWM devient constant et le compteur n'est plus remis à zéro. La valeur N du compteur augmente donc jusqu'à atteindre la valeur de seuil. Cela correspond à la branche 308 (YES) de la condition 306.

Une fois le seuil atteint, le signal RFB de sortie du compteur 212 entraîne l'application de la tension FB à une entrée de la porte 208. Cette tension FB est forcée à une valeur binaire pour maintenir le transistor 106 fermé. Cela correspond à l'étape 310 (FB = 0). Ainsi, quelle que soit la valeur des sorties du circuit 122, la tension FB maintient le transistor 106 fermé.

Les différents éléments de l'alimentation 200, à l'exception de la tension FB, sont ensuite éteints. En particulier, le circuit de commande 114 et le circuit 210 sont éteints. Cela correspond à l'étape 312 (SWITCH OFF SMPS).

Le système entre donc en mode Bypass 320, c'est-à-dire que la charge 103 est alimentée directement par le noeud d'application de la tension VBAT, c'est-à-dire de manière constante par l'intermédiaire de l'interrupteur 106, le transistor 106 étant maintenu fermé par la tension FB.

Un avantage de ce mode de réalisation est que l'augmentation de la tension Vout a été progressive, de la même manière que l'augmentation de la tension V1 provoquée par la modification de la résistance de la boucle de rétroaction.

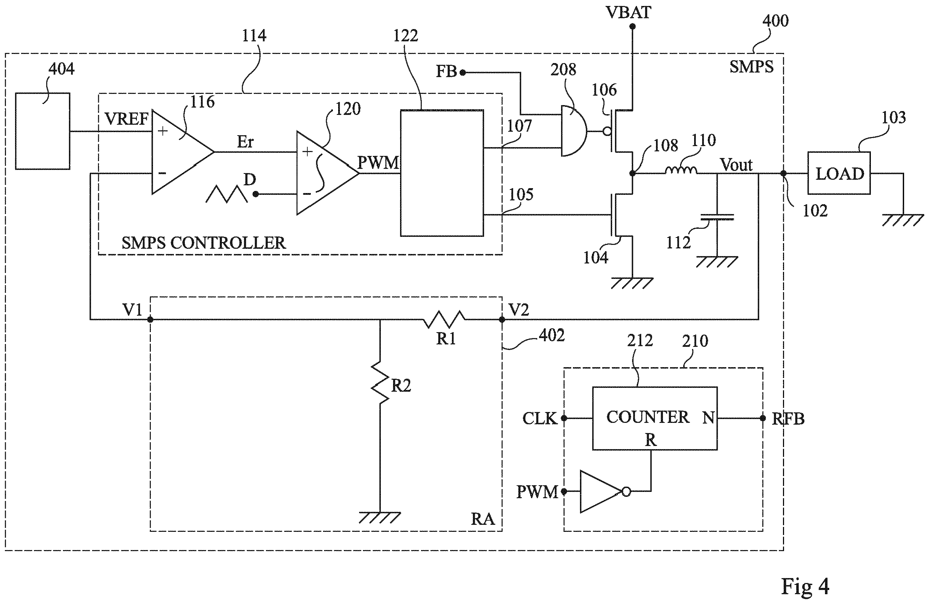

La figure 4 est une représentation schématique d'un mode de réalisation d'une alimentation à découpage 400 alimentant la charge 103. L'alimentation 400 est un convertisseur abaisseur et comprend des éléments similaires à l'alimentation 200. En particulier, l'alimentation 400 comprend le circuit de commande 114, la porte 208, les transistors 106 et 104, l'inductance 110, la capacité 112 et le circuit 210.

Les noeuds V1 et V2 sont couplés par un bloc résistif 402. Le bloc résistif 402 a par exemple une valeur de résistance fixe. Le bloc 402 est par exemple similaire au bloc résistif RA de la figure 1.

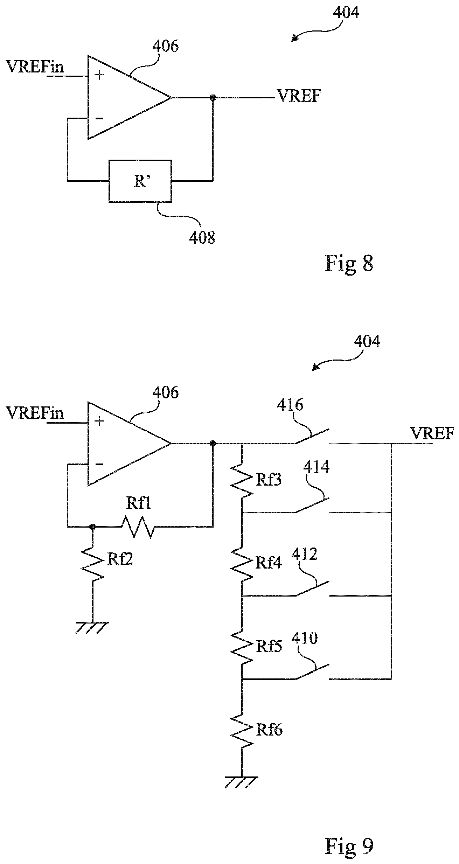

L'alimentation 400 comprend, de plus, un circuit 404 permettant de modifier la tension de référence VREF. Le circuit 404 comprend par exemple un circuit amplificateur ayant un gain réglable. Un autre exemple de circuit 404 comprend un pont diviseur de tension. Deux exemples de circuit 404 sont illustrés en figures 8 et 9.

Le mode de fonctionnement de l'alimentation 400 est similaire à celui décrit en relation avec la figure 3, à l'exception de l'étape 302 qui est remplacée par une étape au cours de laquelle la tension de référence VREF devient supérieure ou égale à la tension d'alimentation divisée par le gain en boucle fermée du système. Les autres étapes restent identiques.

La figure 5 représente une variante d'une partie du mode de réalisation de la figure 2. Plus précisément, la figure 5 représente un autre exemple de bloc résistif R, situé entre les noeuds V1 et V2.

Les noeuds V1 et V2 sont, comme dans l'exemple de la figure 2, couplés par une résistance R3, par exemple égale à la résistance R1. Le noeud V1 est, de plus, couplé à la masse par deux résistances en série R4 et R5. La résistance R5 est connectée à la masse et la résistance R4 est connectée au noeud V1. La valeur de la résistance R4 est par exemple égale à la valeur de la résistance RH de la figure 2, et la résistance R5 est par exemple choisie pour que la somme des valeurs des résistances R4 et R5 soit égale à la valeur de la résistance R2.

Le noeud 402 de connexion des résistances R4 et R5 est, de plus, couplé à la masse par un interrupteur 405, par exemple un transistor MOS.

Ainsi, le premier état du bloc résistif R correspond à un état dans lequel l'interrupteur 405 est ouvert. Le noeud V1 est donc couplé à la masse par une résistance équivalente à R2. Le deuxième état du bloc résistif R correspond à un état dans lequel l'interrupteur 405 est fermé. Le noeud V1 est donc couplé à la masse par la résistance R4.

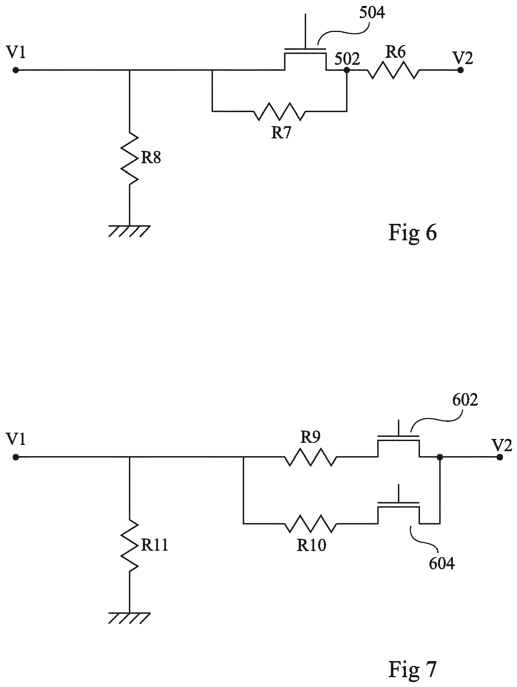

La figure 6 représente une autre variante d'une partie du mode de réalisation de la figure 2. Plus précisément, la figure 6 représente un autre exemple de bloc résistif R, situé entre les noeuds V1 et V2.

Une résistance R6, par exemple égale à la résistance R1, est connectée entre le noeud V2 et un noeud 502. Un interrupteur 504 et une résistance R7 sont connectés en parallèle entre le noeud 502 et le noeud V1. De plus, le noeud V1 est couplé à la masse par la résistance R8, par exemple égale à la résistance R2.

Le premier état du bloc résistif R correspond à l'état dans lequel l'interrupteur 504 est fermé. Ainsi, la résistance entre le noeud V1 et le noeud V2 est donc R6 comme dans le premier état du bloc R de la figure 2.

Le deuxième état du bloc résistif R correspond à l'état dans lequel l'interrupteur 504 est ouvert. Ainsi, la résistance entre les noeuds V1 et V2 vaut R6+R7 et est donc supérieure à la résistance entre le noeud V1 et le noeud V2 du premier état.

La valeur de la résistance R7 est choisie pour que la tension Vout = VREF * (1 + ((R6+R7)/R8) soit supérieure ou égale, de préférence supérieure, à la tension VBAT.

La figure 7 représente une autre variante d'une partie du mode de réalisation de la figure 2. Plus précisément, la figure 7 représente un autre exemple de bloc résistif R, situé entre les noeuds V1 et V2.

Les noeuds V1 et V2 sont connectés par un interrupteur 602, par exemple un transistor, en série avec une résistance R9, par exemple égale à la résistance R1. Les noeuds V1 et V2 sont aussi connectés par un interrupteur 604, par exemple un transistor, en série avec une résistance R10. L'interrupteur 602 et la résistance R9 sont donc en parallèle avec l'interrupteur 604 et la résistance R10. Le noeud V1 est aussi couplé à la masse par la résistance R11, par exemple égale à la résistance R2.

Le premier état du bloc résistif R correspond à l'état dans lequel l'interrupteur 602 est fermé et l'interrupteur 604 est ouvert. Ainsi, la résistance entre le noeud V1 et le noeud V2 est R9.

Le deuxième état du bloc résistif R correspond à l'état dans lequel l'interrupteur 602 est ouvert et l'interrupteur 604 est fermé. Ainsi, la résistance entre le noeud V1 et le noeud V2 est R10.

La valeur de la résistance R10 est choisie pour être supérieure à R9 et pour que la tension Vout = VREF * (1 + R10/R11) soit supérieure ou égale, de préférence supérieure, à VBAT.

Les figures 8 et 9 représentent partiellement des variantes du mode de réalisation de la figure 4. Plus particulièrement, les figures 8 et 9 représentent des exemples de circuits 404. Les circuits 404 des figures 8 et 9 reçoivent en entrée une tension VREFin, par exemple sensiblement constante, et fournissent en sortie la tension de référence VREF.

Dans l'exemple de la figure 8, le circuit 404 comprend un amplificateur opérationnel 406 recevant à son entrée positive (+) la tension VREFin et fournissant en sortie la tension VREF. L'entrée négative (-) de l'amplificateur opérationnel 406 est couplée à sa sortie par un bloc résistif 408 (R') de résistance réglable. Le bloc 408 a par exemple une structure similaire à un bloc résistif R tel que celui décrit en relation avec les figures 2, 5, 6 ou 7.

Dans l'exemple de la figure 9, le circuit 404 comprend, de même, l'amplificateur opérationnel 406 recevant à son entrée positive (+) la tension VREFin. L'entrée négative (-) de l'amplificateur opérationnel 406 est couplée à sa sortie par une résistance Rf1, l'entrée négative de l'amplificateur opérationnel 406 étant couplée à la masse par une résistance Rf2. La sortie de l'amplificateur opérationnel est aussi couplée à la masse par un bloc résistif de résistance réglable. Plus précisément, la sortie de l'amplificateur opérationnel est couplée à la masse par quatre résistances en série Rf3, Rf4, Rf5 et Rf6. En pratique, le nombre de résistances en série peut être quelconque. Chaque noeud connectant deux des quatre résistances en série est couplé à la sortie du circuit 404 par un interrupteur 410, 412 ou 414. De plus, la sortie de l'amplificateur opérationnel est couplée à la sortie du circuit 404 par un interrupteur 416. Les états des interrupteurs 410, 412, 414 et 416 sont modifiés de manière à régler la valeur de la tension VREF.

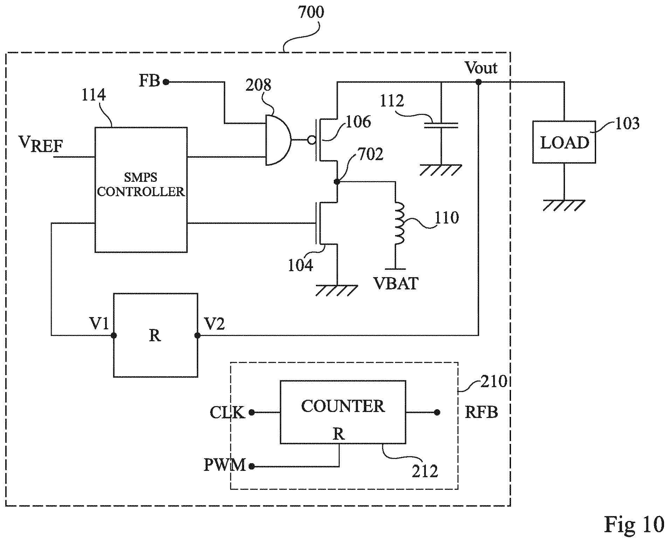

La figure 10 est une représentation schématique d'un autre mode de réalisation d'une alimentation à découpage 700. L'alimentation 700 est ici une alimentation boost, c'est-à-dire que la tension de sortie Vout est supérieure à la tension d'alimentation VBAT.

L'alimentation 700 comprend, comme l'alimentation 200 de la figure 2, le circuit de commande 114 recevant la tension de référence VREF et la tension du noeud V1. L'alimentation 700 comprend de plus un bloc résistif R, tel que ceux décrits en figures 2, 5, 6 et 7, entre les noeuds V1 et V2, le noeud V2 correspondant au noeud auquel est disponible la tension de sortie Vout. L'alimentation comprend de plus les transistors 104 et 106, connectés en série entre le noeud V2 et la masse. Plus précisément, le transistor 106 est connecté entre le noeud V2 et un noeud 702 et le transistor 104 est connecté entre le noeud 702 et la masse. Le transistor 104 est commandé par le circuit de commande 114. Le transistor 106 est commandé, comme en figure 2, par le signal de sortie de la porte 208, recevant en entrée un signal FB et un signal de sortie du circuit de commande 114.

Le noeud 702 est couplé au noeud d'application de la tension VBAT par l'inductance 110. Le noeud V2 est, comme en figures 1 et 2, couplé à la masse par la capacité 112 et par la charge 103.

L'alimentation 700 comprend, de plus, le circuit 210 comprenant le compteur 212.

L'alimentation 700 peut fonctionner en mode bypass, comme les alimentations décrites précédemment, ce qui permet un fonctionnement à moindre bruit. En mode bypass, le transistor 106 est maintenu fermé, le transistor 104 est maintenu ouvert et le circuit de commande 114 peut être éteint.

La transition entre le mode dans lequel la charge est alimentée par l'alimentation à découpage et le mode bypass est similaire à la succession d'étapes décrite en relation avec la figure 3.

Au cours de l'étape 302 de modification de la résistance R, le quotient entre la résistance située entre les noeuds V1 et V2 sur la résistance entre le noeud V1 et la masse diminue. Les caractéristiques de cette diminution, c'est-à-dire par exemple les valeurs des résistances, sont choisies de telle manière que la tension de rétroaction devienne progressivement sensiblement inférieure ou égale à la tension d'alimentation et que la tension de sortie Vout devienne progressivement sensiblement égale à VBAT.

Les autres étapes du mode de fonctionnement décrit en relation avec la figure 3 ne sont pas significativement modifiées.

Selon un autre mode de réalisation d'un convertisseur élévateur, le bloc résistif R est par exemple identique au bloc résistif RA de la figure 1, et l'alimentation 700 comprend un circuit similaire au circuit 404 permettant de modifier la tension de référence VREF. L'étape 302 est remplacée par une étape au cours de laquelle la tension de référence VREF devient inférieure ou égale à la tension d'alimentation divisée par le gain en boucle fermée du système. Les autres étapes restent identiques.

Des modes de réalisation particuliers ont été décrits. Diverses variantes et modifications apparaîtront à l'homme de l'art.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Alimentation à découpage (400) comprenant des premier et deuxième transistors connectés en série, entre la masse et un noeud d'application de la tension d'alimentation, le premier transistor étant apte à être commandé par le signal de sortie d'une porte logique ET connectée en entrée à un circuit de génération de signaux de commande des premier et deuxième transistors et à un noeud d'application d'une tension apte à maintenir le premier transistor fermé quelle que soit la valeur des signaux de commande générés par le circuit de génération, dans laquelle la tension de référence (VREF) de la boucle de rétroaction a une valeur réglable.

2. Alimentation selon la revendication 1, dans laquelle l'alimentation est un convertisseur abaisseur, la tension de référence (VREF) étant adaptée à prendre une valeur supérieure ou égale à la valeur de la tension d'alimentation (VBAT) divisée par le gain en boucle fermée du système.

3. Alimentation selon la revendication 1, dans laquelle l'alimentation est un convertisseur élévateur, la tension de référence (VREF) étant adaptée à prendre une valeur inférieure ou égale à la valeur de la tension d'alimentation (VBAT) divisée par le gain en boucle fermée du système.

4. Alimentation selon l'une quelconque des revendications 1 à 3, comprenant des premier (104) et deuxième (106) transistors connectés en série, le premier transistor étant connecté entre la masse et un premier noeud (108) et le deuxième transistor étant connecté entre le premier noeud et un noeud d'application de la tension d'alimentation (VBAT), les premier et deuxième transistors étant aptes à être commandés par un circuit de génération (122) des signaux de commande des premier et deuxième transistors.

5. Alimentation selon la revendication 4, comprenant un premier circuit (210) apte à détecter si le rapport cyclique d'un signal (PWM) d'entrée du circuit de génération est sensiblement égal à 100 %.

6. Alimentation selon la revendication 4 ou 5, comprenant un deuxième circuit (208) apte à maintenir le deuxième transistor (106) passant si le rapport cyclique du signal d'entrée du circuit de génération (PWM) est sensiblement égal à 100 %.

7. Alimentation selon la revendication 6, dans laquelle le deuxième circuit (208) comprend une porte ET.

8. Alimentation selon la revendication 6 ou 7, dans laquelle le premier circuit comprend un compteur (212) dont l'entrée de mise à zéro est connectée au signal d'entrée du circuit de génération.

9. Alimentation selon l'une quelconque des revendications 1 à 8, dans laquelle la boucle de rétroaction est située entre le noeud de sortie de l'alimentation (V2) et un deuxième noeud (V1).

10. Alimentation selon la revendication 9, dans laquelle le deuxième noeud est couplé à la masse par une première résistance (R2), le deuxième noeud étant couplé au noeud de sortie par une deuxième résistance (R1).

11. Alimentation selon l'une quelconque des revendications 1 à 10, dans laquelle la tension de référence est fournie par un troisième circuit (404) comprenant une boucle de rétroaction résistive de résistance réglable.

12. Alimentation selon l'une quelconque des revendications 1 à 10, dans laquelle la tension de référence est fournie par un troisième circuit (404) comprenant une boucle de rétroaction résistive dont la sortie est couplée à la sortie du circuit (404) par un bloc résistif de résistance réglable.

13. Procédé d'utilisation d'une alimentation comprenant des premier et deuxième transistors connectés en série, entre la masse et un noeud d'application de la tension d'alimentation, le premier transistor étant apte à être commandé par le signal de sortie d'une porte logique ET connectée en entrée à un circuit de génération de signaux de commande des premier et deuxième transistors et à un noeud d'application d'une première tension, le procédé comprenant le passage d'un premier état de la tension de référence de la boucle de rétroaction à un deuxième état et comprenant un mode de fonctionnement dans lequel la première tension maintient le premier transistor fermé quelle que soit la valeur des signaux de commande générés par le circuit de génération.

**14.** Procédé selon la revendication 13, dans lequel l'alimentation est un convertisseur abaisseur, et la tension de référence dans le deuxième état est supérieure ou égale à la tension d'alimentation (VBAT) divisée par le gain en boucle fermée du système.

**15.** Procédé selon la revendication 13, dans lequel l'alimentation est un convertisseur élévateur, et la tension de référence dans le deuxième état est inférieure ou égale à une tension d'alimentation (VBAT) divisée par le gain en boucle fermée du système.

**16.** Procédé selon l'une quelconque des revendications 13 à 15, comprenant :

déterminer, par un premier circuit, si le rapport cyclique d'un signal d'entrée du circuit de génération des signaux de commande de deux transistors est sensiblement égal à 100 % ; et
éteindre les composants de l'alimentation autres qu'un deuxième circuit assurant la connexion entre la sortie de l'alimentation et un noeud d'application de la tension d'alimentation.

Fig 1

EP 3 557 743 A1

Fig 2

EP 3 557 743 A1

SMPS — 300

MODIFY
RESISTANCE — 302

306

N = THRESHOLD
? — NO — 304

308 — YES

FB = 0 — 310

SWITCH OFF
SMPS — 312

320

BYPASS

Fig 3

V1 ———————————— R3 ———— V2

R4

405 — 402

R5

Fig 5

Fig 4

EP 3 557 743 A1

504

V1 502 R6 V2

R7

R8

Fig 6

602

V1 R9 V2

R10

R11

604

Fig 7

Fig 8

Fig 9

Fig 10

**Europäisches Patentamt**

**European Patent Office**

**Office européen des brevets**

# RAPPORT DE RECHERCHE EUROPEENNE

Numéro de la demande

EP 19 16 7173

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | .: "LM2706 Miniature, Variable, Step-Down DC-DC Converter with Bypass for RF Power Amplifiers General Description", , 28 février 2004 (2004-02-28), pages 1-15, XP055530782, Extrait de l'Internet: URL:https://www.digchip.com/datasheets/download_datasheet.php?id=2807956&part-number=LM2706 [extrait le 2018-12-06] | 1-10, 13-16 | INV. H02M3/156 H02M3/158 H02M1/00 G11C5/14 |
| Y | * figure 2 * * page 2 - page 3 * * page 11 * ----- | 11,12 | |
| Y | US 2017/147019 A1 (KIM JONG-CHEOL [KR]) 25 mai 2017 (2017-05-25) * figure 3b * * alinéa [0044] - alinéa [0047] * ----- | 11,12 | |

| DOMAINES TECHNIQUES RECHERCHES (IPC) |
|---|
| H02M G11C |

Le présent rapport a été établi pour toutes les revendications

| Lieu de la recherche | Date d'achèvement de la recherche | Examinateur |
|---|---|---|
| La Haye | 26 août 2019 | Riehl, Philippe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 19 16 7173

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-08-2019

| Document brevet cité au rapport de recherche | Date de publication | Membre(s) de la famille de brevet(s) | Date de publication |
|---|---|---|---|
| US 2017147019 A1 | 25-05-2017 | CN 106873703 A | 20-06-2017 |
| | | KR 20170059703 A | 31-05-2017 |
| | | US 2017147019 A1 | 25-05-2017 |

Pour tout renseignement concernant cette annexe : voir Journal Officiel de l'Office européen des brevets, No.12/82

EPO FORM P0460